# EUROPÄISCHE PATENTANMELDUNG

(11) **EP 1 995 835 A1**
(43) Veröffentlichungstag der Anmeldung: **26.11.2008**
(21) Anmeldenummer: 08103931.5
(22) Anmeldetag: 13.05.2008
(51) Int. Cl.: H01S 5/068, H01S 5/0683

(54) **Verfahren zum Schutz eines Lasers vor Beschädigung durch in einen Resonator unerwünscht einfallendes Licht**

(30) Priorität: 25.05.2007 DE 102007024483
(71) Anmelder: Heidelberger Druckmaschinen AG, 69115 Heidelberg (DE)
(72) Erfinder: Seibert, Claus, 69124 Heidelberg (DE)

(57) **Zusammenfassung**

Es wird ein Verfahren zum Schutz eines Lasers vor Beschädigung durch in einen Resonator unerwünscht einfallendes Licht offenbart. Eine Größe, die ein Maß für die optische Leistung des einfallenden Lichts ist, wird gemessen. Konkret wird die an einem Resonatorspiegel auftretende optische Leistung gemessen. In Reaktion auf das Messergebnis wird eine Pumpleistung für den Laser reduziert, so dass die optische Leistung im Resonator auf einen für den Laser unschädlichen Wert verringert wird.
Das von einer Laserdiode (14) auf der Rückseite (18) emittierte Licht (28) wird dazu von einer Fotodiode (30) gemessen und von der Einheit (32) zur Regelung des Diodenstroms ausgewertet. Eine Überhöhung der Lichtleistung (28) durch reflektiertes Licht (26) führt zur Abschaltung der Laserdiode (14).

## Beschreibung

Die Erfindung betrifft ein Verfahren zum Schutz eines Lasers vor Beschädigung durch in einen Resonator unerwünscht einfallendes Licht, indem eine Größe, die ein Maß für die optische Leistung des einfallenden Lichts ist, gemessen wird und in Reaktion auf das Messergebnis eine Pumpleistung für den Laser reduziert wird, so dass die optische Leistung im Resonator auf einen für den Laser unschädlichen Wert verringert wird.

Bei der Bebilderung oder Herstellung von Druckformen, der Bearbeitung von Druckformrohlingen zu strukturierten Druckformen, insbesondere für den Offsetdruck, werden Diodenlaser, insbesondere einzeln ansteuerbare Diodenlaser auf einem Diodenlaserbarren, eingesetzt. Obgleich potentielle Reflexionsflächen in einem Druckformbelichtungsgerät prophylaktisch geschwärzt oder absorbierend beschichtet werden, können in der Praxis dennoch unerwünschte Lichtreflexionen beispielsweise bei einer Bebilderung nahe am Rand der Druckform auftreten, zum Beispiel wenn sich während der Betriebszeit des Gerätes Aluminium-Abrieb der Druckformen anreichert und die Reflektivität erhöht, so dass die Gefahr besteht, dass unerwünscht Laserlicht zurück in den oder die bebildernden Laser gelangt.

In geläufiger Weise kann ein Schutz von Rückreflexen oder anderem parasitär einfallenden Licht durch die Verwendung von Faraday-Isolatoren zwischen einem Laser und potentiell reflektierenden Oberflächen erreicht werden, wobei die Faraday-Isolatoren die Laserstrahlung nur in die Richtung vom Laser weg transmittieren und Licht in die entgegengesetzte Richtung stark abschwächen. Gerade im Zusammenhang einer Druckformbebilderung mit einer großen Anzahl von parallel eingesetzten Belichtungskanälen hat diese Konfiguration aber neben der sich sofort stellenden Bauraumproblematik inakzeptabel hohe Kosten zur Folge und scheidet daher zumindest schon aus kommerziellen Gründen für die Praxis aus.

Alternativ zu einem passiven Schutz vor unerwünscht einfallendem Licht wird beispielsweise im Dokument US 6,305,851 B1 ein aktives System zur Vermeidung der Beschädigung eines Lasers durch Rückreflexionen im Zusammenhang einer optischen Kommunikationseinrichtung beschrieben. Das rückreflektierte Licht wird gemessen. Eine messende Fotodiode kann dabei mittels eines optischen Kopplers in den Lichtweg eingebracht sein. Der Laser wird abgeschaltet, wenn ein schlechter Kontakt zu einem optischen Verbinder derart existiert, dass zuviel Licht zurückreflektiert wird. Bei einem Einsatz dieser technischen Lehre im Zusammenhang einer Druckformbebilderung ist das Einfügen von zusätzlichen optischen Koppelelementen (Strahlteilern) und Messfotodioden nachteilig mit einem vergrößerten Bauraum verbunden.

Aufgabe der vorliegenden Erfindung ist es, schnell zu detektieren, dass unerwünscht Licht in einen Laser, insbesondere einen Laser einer Bebildungseinrichtung für eine Druckform, einfällt, um den Laser vor Beschädigung zu schützen.

Diese Aufgabe wird erfindungsgemäß durch ein Verfahren zum Schutz eines Lasers vor Beschädigung durch in einen Resonator unerwünscht einfallendes Licht mit den Merkmalen gemäß Anspruch 1 gelöst. Vorteilhafte Weiterbildungen der Erfindung sind in den abhängigen Ansprüchen charakterisiert.

Im erfindungsgemäßen Verfahren zum Schutz eines Lasers, insbesondere in einer Bebildungseinrichtung für eine Druckform, vor Beschädigung durch in einen Resonator unerwünscht einfallendes Licht, insbesondere zurückreflektiertes Licht des Lasers oder Laserlicht, wird eine Größe, die ein Maß für die optische Leistung des einfallenden Lichts ist, gemessen. Konkret wird die an einem Resonatorspiegel auftretende optische Leistung gemessen. In Reaktion auf das Messergebnis wird eine Pumpleistung für den Laser reduziert, so dass die optische Leistung im Resonator auf einen für den Laser unschädlichen Wert verringert wird, insbesondere unter einen Wert einer gewöhnlichen oder regelmäßigen Betriebsleistung, oder so dass der Laser ausgeschaltet wird. Mit anderen Worten, es wird nicht das zurückreflektierte Licht gemessen, sondern die optische Leistung im Resonator an einem Resonatorspiegel detektiert oder quantitativ erfasst. Anders formuliert, es wird ein Teil der optischen Leistung im Resonator gemessen. Die gemessene optische Leistung ist insbesondere die aktuelle optische Leistung, das heißt vor einer Maßnahme zur Vermeidung einer Beschädigung des Lasers. Die Messung kann als intra-cavity Messung bezeichnet werden. Die Größe kann ein direktes oder indirektes Maß für die optische Leistung des einfallenden Lichts sein. Anders ausgedrückt, die Größe kann direkt eine messtechnische Erfassung der optischen Leistung des einfallenden Lichts ermöglichen oder kann indirekt für die Berechnung der optischen Leistung des einfallenden Lichts dienen.

Erfindungsgemäß erfolgt eine Messung einer Größe, die direkte Relevanz für eine potentielle Beschädigung des Lasers hat. Eine derartige Messung und deren Auswertung können schnell erfolgen. Während das einfallende Licht nur mittelbare Ursache der Beschädigungsgefahr ist, wird in vorteilhafter Weise im erfindungsgemäßen Verfahren die tatsächlich relevante physikalische Größe, die optische Leistung im Resonator des Lasers, welche unmittelbare Auswirkung hat, direkt erschlossen und verarbeitet. Die Reaktion auf eine schädigende Gefahr kann daher schnell erfolgen. In diesem Zusammenhang kann auch ein kompakter Aufbau für die Durchführung des erfindungsgemäßen Verfahrens realisiert werden.

Der Resonatorspiegel kann insbesondere ein anderer als der auskoppelnde Resonatorspiegel (Austrittsfacette des Lasers), insbesondere die Rückfacette des Resonators (mit zwei Resonatorspiegeln) sein. Auch der für die Messung verwendete Resonatorspiegel kann auskoppelnd sein. Des Weiteren kann die auftretende optische Leistung mittels eines hinter dem Resonatorspiegel, insbesondere außerhalb des Resonators, positionierten lichtempfindlichen Detektors, insbesondere einer Photodiode, gemessen werden.

Bevorzugt ist der Laser ein Einmodenlaser (single-mode laser oder single-mode emitter). Anders ausgedrückt, bevorzugt wird nur eine Mode des Lasers betrieben. Diese Betriebsart ist aufgrund ihrer Strahleigenschaften besonders vorteilhaft für die Bebilderung von Druckformen. Gleichzeitig reagieren derartige Laser besonders empfindlich auf unerwünscht einfallendes Licht, so dass ein erfindungsgemäßer Schutz vor Beschädigung zweckmäßig ist.

In einer besonders vorteilhaften Ausführungsform des erfindungsgemäßen Verfahrens zum Schutz eines Lasers vor Beschädigung wird die Pumpleistung des Lasers gleichzeitig mittels eines Pumpgrößenreglers und eines Lichtleistungsreglers geregelt. Dabei kann die optische Leistung des Lasers an der (oberen) Lichtleistungsgrenze des Lichtleistungsreglers größer als die optische Leistung des Lasers an der (oberen) Pumpgrößengrenze des Pumpgrößenreglers sein. Besonders vorteilhaft ist dabei, dass der eine Regler für den Betrieb des Lasers genutzt und der andere Regler für den Schutz des Lasers vorgesehen ist.

Bevorzugt wird das Verfahren bei Lasern eingesetzt, deren Pumpleistungsquelle direkt modulierbar ist. Der Laser kann ein einzelner Diodenlaser, ein Diodenlaser auf einem Diodenlaserbarren, ein VCSEL mit internem Resonator, ein VCSEL mit externem Resonator, (Vertical Cavity Surface Emitting Laser, oberflächenemittierender Laser), ein Faserlaser oder ein Festkörperlaser sein. Faserlaser oder Festkörperlaser können insbesondere diodengepumpt sein.

Besonders bevorzugt, insbesondere im Zusammenhang mit der Bebilderung von Druckformen, ist im erfindungsgemäßen Verfahren der Laser ein einzeln ansteuerbarer Diodenlaser auf einem Diodenlaserbarren ist.

Es ist noch zu betonen, dass im erfindungsgemäßen Verfahren der Resonatorspiegel ein Resonatorspiegel des Lasers (bevorzugt) oder ein Resonatorspiegel eines anderen Lasers sein kann. Insbesondere für die Ausführungsform der Durchführung des Verfahrens an Diodenlasern auf einem Diodenlaserbarren, kann die Messung an einem Diodenlaser statt für diesen oder neben diesem auch als Grundlage für eine Verringerung der optischen Leistung in anderen Diodenlasern, welche potentiell auch einer Beschädigungsgefahr ausgesetzt sind, weil die Diodenlaser auf dem Barren kompakt liegen, genutzt werden. Die Verringerung der optischen Leistung in einem anderen Laser kann auch zu einem späteren Zeitpunkt als die Messung erfolgen. In einer konkreten Ausführungsform im Zusammenhang mit der Belichtung von Druckformen kann ein am Rand des Diodenlaserbarrens liegender Diodenlaser als ein Sensorkanal benutzt werden: Dieser Diodenlaser wird mit einem geringen Strom betrieben. Anhand seines Photodiodensignals wird die Lage der Druckformkante auf einem aufnehmenden Zylinder bestimmt und daraus der Zeitpunkt berechnet werden, an dem die anderen Diodenlaser sicher eingeschaltet werden können.

Im erfindungsgemäßen Verfahren zum Schutz eines Lasers vor Beschädigung kann zur Feststellung, ob eine Reaktion erforderlich ist, der Wert der gemessenen Größe oder ein von diesem Wert durch Verarbeitung erschlossener Wert mit einem unteren Grenzwert und/oder einem oberen Grenzwert verglichen werden und die Pumpleistung reduziert werden, wenn der im Vergleich betrachtete Wert unterhalb des unteren Grenzwertes und/oder oberhalb des oberen Grenzwertes liegt.

Wie bereits eingangs erwähnt, ist es bevorzugt, das erfindungsgemäße Verfahren für einen Laser, der Teil einer Bebilderungseinrichtung für Druckformen ist, während der Bebilderung einer Druckform durchzuführen. Insbesondere kann die Bebilderungseinrichtung für Offsetdruckformen ausgelegt sein. Die Druckformen können Druckplatten sein. Die Bebilderung einer Druckform kann auch als Druckformherstellung bezeichnet werden. Besondere Merkmale einer derartigen Bebilderungseinrichtung sind in den publizierten Dokumenten DE 10 2005 042 680 A1 und WO 2002/45007 A1 offenbart. Der Inhalt beider Dokumente wird durch Bezugnahme explizit in den Offenbarungsgehalt dieser Darstellung mit aufgenommen. Das erfindungsgemäße Verfahren ermöglicht in vorteilhafter Weise ein Abschalten der Bebilderungskanäle, sobald einer oder mehrere Laserbildpunkte nicht mehr auf eine (absorbierende) Druckfläche der Druckform, sondern auf eine reflektierende Fläche, wie beispielsweise der Oberfläche des die Druckform aufnehmenden Zylinders, fallen. Laser, die geeignet zur Bebilderung von Druckformen, insbesondere Offsetdruckformen sind, können Ausgangsleistungen von mehr als 100 mW, bevorzugt mehr als 150 mW erreichen.

Weitere Vorteile und vorteilhafte Ausführungsformen und Weiterbildungen der Erfindung werden in der nachfolgenden Beschreibung unter Bezugnahme auf die beigefügten Figuren dargestellt. Es zeigt im Einzelnen:
- Figur 1: eine schematische Darstellung einer Ausführungsform einer Bebilderungseinrichtung mit einem Diodenlaser auf einem Diodenlaserbarren für die Bebilderung von Druckformen, geeignet zur Durchführung des erfindungsgemäßen Verfahrens,
- Figur 2: eine graphische Darstellung der optischen Leistung im Resonator mit und ohne unerwünscht einfallendes rückreflektiertes Licht,
- Figur 3: ein Schema zur Erläuterung der Wirkung eines einfachen Regelkreises für die Regelung des Diodenlasers,
- Figur 4: ein Schema zur Erläuterung der Wirkung eines doppelten Regelkreises für die Regelung des Diodenlasers, und
- Figur 5: ein Schema zur Erläuterung der Wirkung des doppelten Regelkreises für die Regelung des Diodenlasers, in der die Lichtleistungsgrenze höher als die Stromleistungsgrenze (Pumpleistungsgrenze) gesetzt ist.

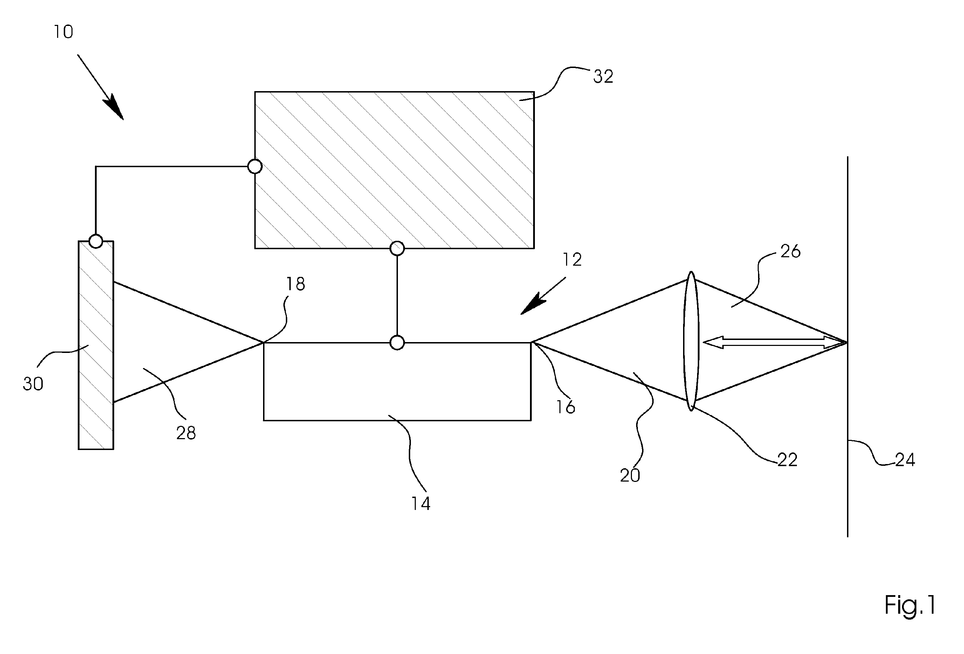

Die Figur 1 zeigt schematisch eine Ausführungsform einer Bebilderungseinrichtung 10 mit einem Diodenlaser 14 auf einem Diodenlaserbarren 12 für die Bebilderung von Druckformen, geeignet zur Durchführung des erfindungsgemäßen Verfahrens. Die Diodenlaser 14 sind einzeln ansteuerbar, jeder Diodenlaser 14 ist die intensitätsmodulierbare Lichtquelle eines Bebilderungskanals. Die Bildpunkte liegen disjunkt oder überlappungsfrei auf der zu bebildernden Druckform. Der Diodenlaser 14 weist eine Frontfacette 16 und eine Rückfacette 18 auf. Aus der Frontfacette 16 tritt emittiertes Licht 20 aus, welches mittels einer Abbildungsoptik 22 auf eine Druckform abgebildet wird. Gezeigt in Figur 1 ist eine reflektierende Oberfläche 24, welche bewirkt, dass rückreflektieres Licht 26 in den Strahlengang von der Oberfläche 24 hin zur Frontfacette 16 des Diodenlasers 14 und schließlich in den Resonator des Diodenlasers 14 gelangt. Das von der reflektierenden Oberfläche in den Laser zurückreflektierte Licht 26 wird im Resonator verstärkt. Aus der Rückfacette 18 des Diodenlasers 14 austretendes Licht 28 wird auf eine Photodiode 30 quantitativ gemessen. Die Photodiode 30 ist mit der Regelungseinheit 32 des Diodenlasers 14, bevorzugt realisiert in Form eines ASICs (Application-Specific Integrated Circuit, anwendungspezifischer integrierter Schaltkreis). Die Regelungseinheit 32 steuert den Diodenlaser 14 an, genauer ausgedrückt der Pumpstrom des Diodenlasers 14 kann mittels der Regelungseinheit 32 variiert werden. Erfindungsgemäß wird mittels der Photodiode das Auftreten einer hohen optischen Leistung im Resonator gemessen, da dann die Intensität des austretenden Lichtes 28 ansteigt. Die Regelungseinheit 32 verringert in Reaktion auf eine festgestellte hohe Intensität dann den Pumpstrom des Diodenlasers 14, um die optische Leistung im Resonator abzusenken. Mit anderen Worten, die Regelungseinheit 32, insbesondere das ASIC regelt den Diodenlaserstrom beim Überschreiten eines maximalen Photodiodensignals auf einen Wert, bei dem der Diodenlaser nicht mehr beschädigt werden kann. In einer bevorzugten Ausführungsform ist der in Figur 1 gezeigte Aufbau kompakt oder integriert realisiert.

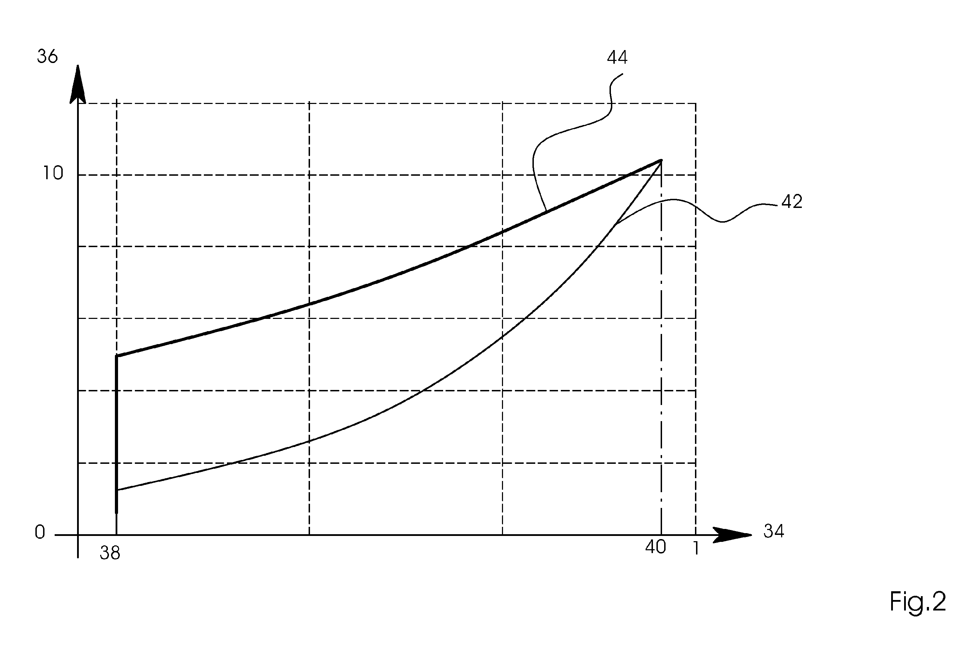

Die Figur 2 ist eine graphische Darstellung der optischen Leistung 36 im Resonator in Funktion der Position 34 im Resonator mit und ohne unerwünscht einfallendes rückreflektiertes Licht für eine bevorzugte Ausführungsform eines Diodenlasers 14 auf einem Diodenlaserbarren 12 in einer Bebilderungseinrichtung 10 für Druckformen. Erfindungsgemäß wird die Tatsache genutzt, dass die auf der Rückfacette 18 des Diodenlasers 14 austretende optische Leistung sehr sensitiv auf die Rückreflexionen von der reflektierenden Oberfläche 24 ist.

Aufgrund der Resonatorkonfiguration des Diodenlasers 14 stellt sich ein bestimmtes Verhältnis der Leistungen an der Frontfacette 16 und der Rückfacette 18 ein. Der Nominalwert an der Rückfacette 18 kann in geläufigen Situationen um einen Faktor 3 bis 4 beim Auftreten von Rückreflexionen erhöht sein (Position 38 der Rückfacette). Dagegen kann der Nominalwert an der Frontfacette 16 im Wesentlichen unverändert bleiben (Position 40 der Frontfacette). Die Figur 2 zeigt graphisch den Verlauf der optischen Leistung ohne Rückreflexion 42 und den Verlauf der optischen Leistung mit Rückreflexion 44. Beide Verläufe steigen monoton von der Position 38 der Rückfacette zu der Position 40 der Frontfacette an. Mit Hilfe der Photodiode 30 misst die Regelungseinheit 32 diese Abweichung vom Nominalwert und schaltet bei Überschreiten eines festgelegten Limits den Diodenlaser 14 ab.

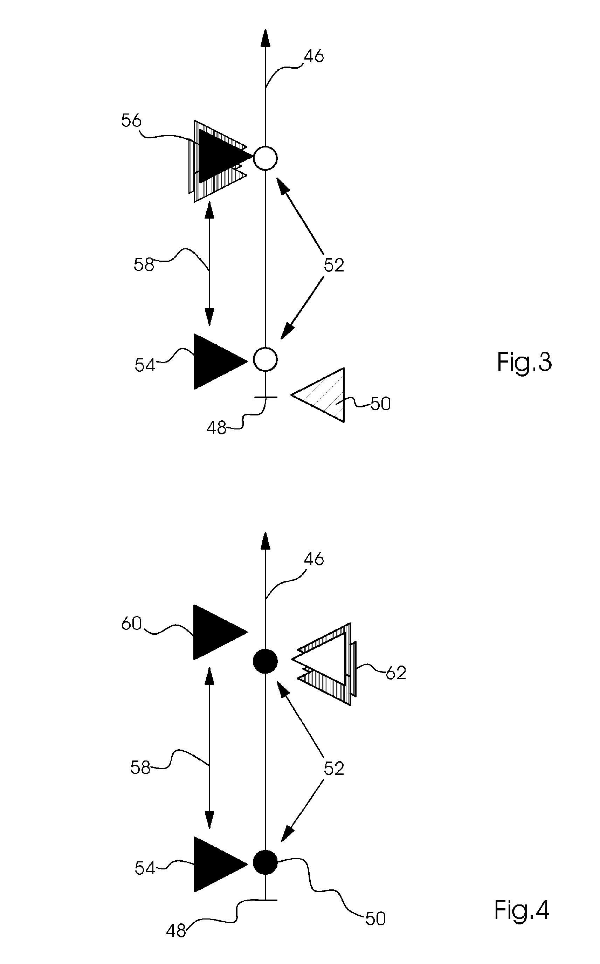

Die Figur 3 bezieht sich schematisch auf die Wirkung eines einfachen Regelkreises für die Regelung des Diodenlasers 14. Aufgetragen entlang der Laserstrom-Lichtleistung-Achse 46 sind Werte für den Pumpgrößenregler 48, hier im Fall des Diodenlasers 14 der Bebilderungseinrichtung 10 ein Stromregler, und für den Lichtleistungsregler 50. Es existieren zunächst zwei Arbeitspunkte 52, welche den Situationen "Diodenlaser aus" und "Diodenlaser an" entsprechen. Der Sollwert des Stromreglers wird für den Betrieb des Diodenlasers 14 zwischen dem Niveau "Laserstrom aus" 54 und dem Bebilderungsstrom 56 hin- und hergeschaltet (Umschaltung 58). In dieser einfachen Konfiguration, die auch als open loop bezeichnet wird, ist der Lichtleistungsregler deaktiviert. Der Photodiodenstrom kann zum Auslesen über den internen ADC verwendet werden.

In der Figur 4 ist eine schematische Darstellung zur Erläuterung der Wirkung eines doppelten Regelkreises für die Regelung des Diodenlasers 14. Diese Konfiguration kann als closed loop bezeichnet werden. Auch in dieser Figur sind entlang der Laserstrom-Lichtleistung-Achse 46 Werte für den Pumpgrößenregler 48, hier Stromregler, und für den Lichtleistungsregler 50 aufgetragen und die zwei Arbeitspunkte 52 gezeigt. Eine Umschaltung 58 der Sollwerte des Stromreglers erfolgt nunmehr zwischen Niveau "Laserstrom aus" 54 und Überstrom 60, welcher größer als der obere Arbeitspunkt 52 ist. Der Lichtleistungsregler 50 hingegen wird aus den oberen Arbeitspunkt 52 eingestellt, die Bebilderungslichtleistung 64. In dieser Situation gewinnt jeweils der Regler, der den geringeren Strom für den Diodenlaser 14 treiben will, die Kontrolle über den Pumpstrom.

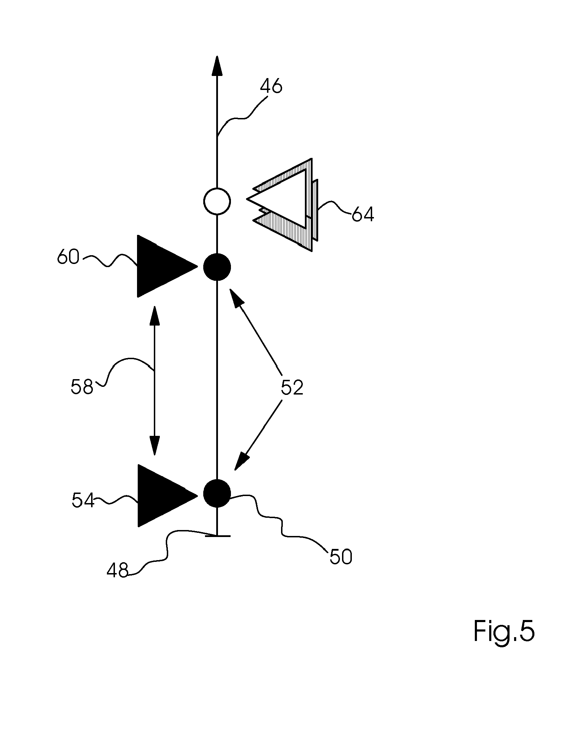

Die Figur 5 zeigt ein Schema zur Erläuterung der Wirkung des doppelten Regelkreises für die Regelung des Diodenlasers, in der die Lichtleistungsgrenze höher als die Stromleistungsgrenze (Pumpleistungsgrenze) gesetzt ist. Diese Konfiguration kann auch als protected mode bezeichnet werden und dient der Vermeidung von Beschädigungen durch Rückreflexionen von Laserlicht. Entlang der schon in den Figuren 3 und 4 gezeigten Laserstrom-Lichtleistung-Achse 46 Werte sind erneut die zwei Arbeitspunkte 52 aufgetragen. Es erfolgt eine Umschaltung 58 des Sollwerts des Stromreglers (Pumpgrößenregler 48) zwischen Niveau "Laserstrom aus" 54 und dem Überstrom 60, welcher in diesem Fall auf dem oberen Arbeitspunkt 52 liegt. Die Bebilderungslichtleistung 64 ist höher als der Überstrom 60 gesetzt. Dadurch wird ein fest eingeprägter Strom geregelt. Im Falle einer auftretenden Rückreflexion regelt der Lichtleistungsregler 50 die maximale Lichtleistung, indem der Laserstrom reduziert wird.

### BEZUGSZEICHENLISTE

- 10: Bebilderungseinrichtung
- 12: Diodenlaserbarren
- 14: Diodenlaser
- 16: Frontfacette
- 18: Rückfacette
- 20: emittiertes Licht
- 22: Abbildungsoptik
- 24: reflektierende Oberfläche
- 26: rückreflektiertes Licht
- 28: austretendes Licht
- 30: Photodiode
- 32: Regelungseinheit
- 34: Position im Resonator
- 36: optische Leistung
- 38: Position Rückfacette
- 40: Position Austrittsfacette
- 42: Verlauf ohne Rückreflexion
- 44: Verlauf mit Rückreflexion
- 46: Laserstrom-Lichtleistung-Achse
- 48: Pumpgrößenregler
- 50: Lichtleistungsregler
- 52: Arbeitspunkte
- 54: Laserstrom aus
- 56: Bebilderungsstrom
- 58: Umschaltung
- 60: Überstrom
- 62: Bebilderungslichtleistung
- 64: maximale Lichtleistung

## Patentansprüche

1. Verfahren zum Schutz eines Lasers vor Beschädigung durch in einen Resonator unerwünscht einfallendes Licht, indem eine Größe, die ein Maß für die optische Leistung des einfallenden Lichts ist, gemessen wird und in Reaktion auf das Messergebnis eine Pumpleistung für den Laser reduziert wird, so dass die optische Leistung im Resonator auf einen für den Laser unschädlichen Wert verringert wird,
**dadurch gekennzeichnet,**
**dass** die an einem Resonatorspiegel auftretende optische Leistung gemessen wird.

2. Verfahren zum Schutz eines Lasers vor Beschädigung gemäß Anspruch 1,
**dadurch gekennzeichnet,**
**dass** der Resonatorspiegel vom auskoppelnden Resonatorspiegel verschieden ist und/oder die Rückfacette (18) des Resonators ist.

3. Verfahren zum Schutz eines Lasers vor Beschädigung gemäß Anspruch 1 oder 2,
**dadurch gekennzeichnet,**
**dass** die auftretende optische Leistung mittels eines hinter dem Resonatorspiegel positionierten lichtempfindlichen Detektors gemessen wird.

4. Verfahren zum Schutz eines Lasers vor Beschädigung gemäß Anspruch 3,
**dadurch gekennzeichnet,**
**dass** der lichtempfindliche Detektor eine Photodiode (30) ist.

5. Verfahren zum Schutz eines Lasers vor Beschädigung gemäß einem der vorstehenden Ansprüche,
**dadurch gekennzeichnet,**
**dass** nur eine Mode des Lasers betrieben wird (single-mode laser).

6. Verfahren zum Schutz eines Lasers vor Beschädigung gemäß einem der vorstehenden Ansprüche,
**dadurch gekennzeichnet,**
**dass** die Pumpleistung des Lasers gleichzeitig mittels eines Pumpgrößenreglers (48) und eines Lichtleistungsreglers (50) geregelt wird.

7. Verfahren zum Schutz eines Lasers vor Beschädigung gemäß Anspruch 6,
**dadurch gekennzeichnet,**
**dass** die optische Leistung des Lasers an der Lichtleistungsgrenze des Lichtleistungsreglers (50) größer als die optische Leistung des Lasers an der Pumpgrößengrenze des Pumpgrößenreglers (48) ist.

8. Verfahren zum Schutz eines Lasers vor Beschädigung gemäß einem der vorstehenden Ansprüche,
**dadurch gekennzeichnet,**
**dass** die Pumpleistungsquelle direkt modulierbar ist.

9. Verfahren zum Schutz eines Lasers vor Beschädigung gemäß einem der vorstehenden Ansprüche,
**dadurch gekennzeichnet,**
**dass** der Laser ein einzelner Diodenlaser, ein Diodenlaser (14) auf einem Diodenlaserbarren (12), ein VCSEL, ein Faserlaser oder ein Festkörperlaser ist.

10. Verfahren zum Schutz eines Lasers vor Beschädigung gemäß einem der vorstehenden Ansprüche,
**dadurch gekennzeichnet,**
**dass** der Laser ein einzeln ansteuerbarer Diodenlaser (14) auf einem Diodenlaserbarren (12) ist.

11. Verfahren zum Schutz eines Lasers vor Beschädigung gemäß einem der vorstehenden Ansprüche,
**dadurch gekennzeichnet,**
**dass** das Resonatorspiegel ein Resonatorspiegel des Lasers oder ein Resonatorspiegel eines anderen Lasers ist.

12. Verfahren zum Schutz eines Lasers vor Beschädigung gemäß einem der vorstehenden Ansprüche,
**dadurch gekennzeichnet,**
**dass** zur Feststellung, ob eine Reaktion erforderlich ist, der Wert der gemessenen Größe oder ein von diesem Wert durch Verarbeitung erschlossener Wert mit einem unteren Grenzwert und/oder einem oberen Grenzwert verglichen wird und die Pumpleistung reduziert wird, wenn der im Vergleich betrachtete Wert unterhalb des unteren Grenzwertes und/oder oberhalb des oberen Grenzwertes liegt.

13. Verfahren zum Schutz eines Lasers vor Beschädigung gemäß einem der vorstehenden Ansprüche,
**dadurch gekennzeichnet,**
**dass** das Verfahren für einen Laser, der Teil einer Bebilderungseinrichtung (10) für Druckformen ist, während der Bebilderung einer Druckform durchgeführt wird.
